Europäisches Patentamt

European Patent Office

Office européen des brevets

(11) Publication number: **0 107 921**
**B1**

## EUROPEAN PATENT SPECIFICATION

(45) Date of publication of patent specification: **28.06.89**

(51) Int. Cl.⁴: **G 11 C 11/24**

(21) Application number: **83305872.0**

(22) Date of filing: **29.09.83**

(54) A dynamic semiconductor memory device.

(30) Priority: **29.09.82 JP 170682/82**

(43) Date of publication of application:
**09.05.84 Bulletin 84/19**

(45) Publication of the grant of the patent:
**28.06.89 Bulletin 89/26**

(84) Designated Contracting States:
**DE FR GB**

(56) References cited:
**EP-A-0 103 834**
**US-A-3 810 124**
**US-A-4 115 871**

**IBM TECHNICAL DISCLOSURE BULLETIN, vol.
25, no. 3B, August 1982, pages 1735-1736, New
York, US; L.M. TERMAN: "Cross-coupled word
line clamping circuit"**

(73) Proprietor: **FUJITSU LIMITED**
**1015, Kamikodanaka Nakahara-ku
Kawasaki-shi Kanagawa 211 (JP)**

(72) Inventor: **Takemae, Yoshihiro**
**Shuwa-Akasaka-Hinokicho-Rejidensu 303, 8-13-
24**
**Akasaka Minato-ku Tokyo 107 (JP)**
Inventor: **Nakano, Tomio**
**12-404, 1-11-2, Shirahatadai Miyamae-ku
Kawasaki-shi Kanagawa 213 (JP)**
Inventor: **Sato, Kimiaki**
**311, 5-12-24, Minamiaoyama
Minato-ku Tokyo 107 (JP)**

(74) Representative: **Sunderland, James Harry et al
HASELTINE LAKE & CO Hazlitt House 28
Southampton Buildings Chancery Lane
London WC2A 1AT (GB)**

## Description

The present invention relates to a dynamic semiconductor memory device having memory cells of a one-transistor one-capacitor type.

Generally, a dynamic semiconductor memory device such as a one-transistor one-capacitor type dynamic random access memory (DRAM) has memory cells each consisting of one metal-insulator semiconductor (MIS) transistor having a drain connected to a bit line, a gate connected to a word line, and a source and also having one capacitor, i.e., a depletion MOS diode capacitor, having one electrode connected to the source of the MIS transistor. The potential of another electrode opposed to the above-mentioned one electrode (hereinafter referred to as an opposed electrode) is preferably fixed at a low voltage $V_{ss}$ of a power supply.

In a conventional technique for simplifying the process of manufacturing opposed electrodes (US—A—4 115 871), non-selected word lines are utilized as opposed electrodes since non-selected word lines are clamped, at one end thereof, at the low voltage $V_{ss}$ by means of word decoders. If the opposed electrodes of the cell capacitors are independently formed without utilizing non-selected word lines, an additional layer, for example, a polycrystalline layer, is necessary, thereby rendering the manufacturing process more complex.

In such a conventional one-transistor one-capacitor DRAM, there exists the possibility of the destruction of data stored in a memory cell adjacent to a selected memory cell during memory cell selection (described in detail later with reference to the drawings).

US—A—3 810 124 discloses a semiconductor memory device as set forth in the preambale of the accompanying claim 1.

According to the present invention, there is provided a dynamic semiconductor memory device comprising:
a plurality of word lines;
a plurality of bit lines;
one-transistor one-capacitor type memory cells connected between the word lines and the bit lines; and clamping circuitry, comprising a plurality of flip-flops, for clamping non-selected word lines to a low voltage of power source;
characterised in that in each memory cell, the transistor has a gate connected to a certain one of the word lines, a first electrode connected to one of the bit lines, and a second electrode, and the capacitor has an electrode connected through a node to the second electrode of the transistor, and has another electrode connected to the word line adjacent to said certain one word line, the two electrodes of the capacitor being opposed through an insulating film; and in that
said clamping circuitry comprises:
a respective flip-flop connected between each word line and each adjacent word line, whereby each flip-flop is connected to a pair of word lines and each word line is connected to two flip-flops, each flip-flop being operable to clamp a non-selected one of the pair of word lines to which it is connected at the low voltage of said power source; and each flip-flop comprising a pair of cross-coupled transistors each having a gate connected to a respective one of the pair of word lines.

An embodiment of the present invention can provide a dynamic semiconductor memory device in which data destruction during memory cell selection is prevented, thereby preventing an error in a reading operation.

Reference is made, by way of example, to the accompanying drawings in which;
Figure 1 is a circuit diagram of an example of a conventional DRAM;
Figure 2 is a waveform diagram showing the operation of the DRAM of Fig. 1;
Figure 3 is a circuit diagram of a DRAM according to an embodiment of the present invention;
Figure 4 is a waveform diagram showing the operation of the DRAM of Fig. 3;
Figure 5 is a block diagram of a DRAM according to another embodiment of the present invention;
Figure 6A is a plan view of the DRAM of Fig. 3 showing the structure thereof;
Figure 6B is a cross-sectional view of Fig. 6A taken along the line X—X' of Fig. 6A;
Figure 6C is a cross-sectional view of Fig. 6A taken along the line Y—Y' of Fig. 6A.

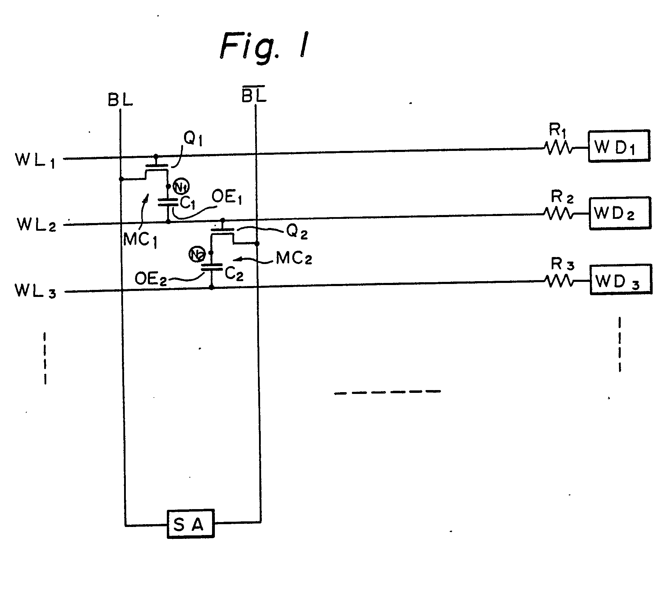

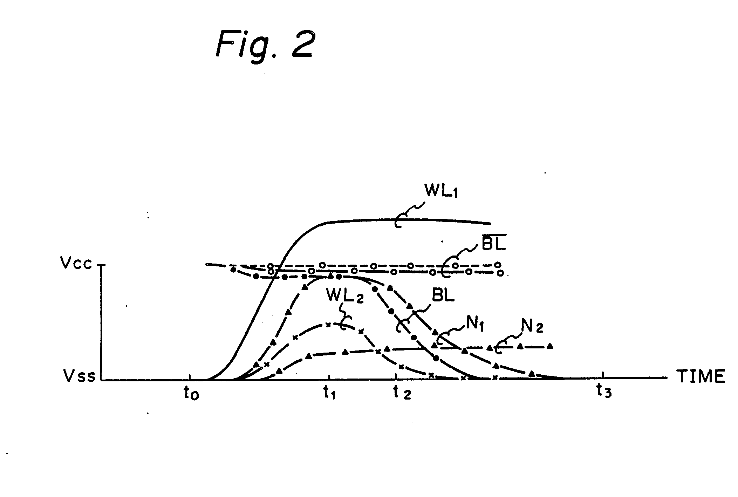

Before describing the embodiments of the present invention, a conventional DRAM and the problems involved therein are described with reference to Figs. 1 and 2.

Figure 1 shows an example of a conventional DRAM. In Fig. 1 $WL_1$, $WL_2$, ... are word lines formed by a polysilicon layer; BL and $\overline{BL}$ are one pair of bit lines (other bit lines are omitted in the drawing); SA is a sense amplifier; $WD_1$, $WD_2$, ... are word decoders; $MC_1$ and $MC_2$ are memory cells; $Q_1$ and $Q_2$ are metal-oxide semiconductor (MOS) transistors having silicon gates; and $C_1$ and $C_2$ are MOS capacitors. One of the transistors and one of the capacitors constitute a memory cell. In this DRAM, the opposed electrode $OE_1$ of the capacitor $C_1$ in the memory cell $MC_1$, which is selected by raising the potential of the word line $WL_1$, is connected to the word line $WL_2$ adjacent to the word line $WL_1$, which is selected to have a high potential. The opposed electrode $OE_2$ of the capacitor $C_2$ in the memory cell $MC_2$, which is selected by raising the potential of the word line $WL_2$, is connected to the next word line $WL_3$ adjacent to the word line $WL_2$, and so on. Thus, the adjacent word lines are used as opposed electrodes of the MOS capacitors.

When a memory cell, for example, $MC_1$, is selected, the selected word line $WL_1$ is driven to a voltage higher than a high voltage $V_{cc}$ of a power supply by means of the word decoder $WD_1$, and the non-selected word lines $WL_2$ and $WL_3$ are substantially fixed to the low voltage $V_{ss}$, which is generally equal to 0 V. If a P-type semiconductor substrate is employed, and N-type inversion layer is formed immediately under one part of a word line by means of an ion injection technique and so on so as to form a MOS capacitor between that part of the word line and the inversion layer. The inversion layer is formed so as to contact the drain or the source of the MOS transistor. Therefore, the non-selected word lines can be used as the opposed electrodes of the MOS capacitors.

However, problems exist with the above-described conventional DRAM, which are explained with reference to Fig. 2. For example, when the cell $MC_1$ is in a "0" storing state so that a node $N_1$ connected to the source of the MOS transistor $Q_1$ and to an electrode of the MOS capacitor $C_1$ is 0 V and when the word line $WL_1$ is selected at a time $t=t_0$, the node $N_1$ is charged by the bit line BL, which was precharged to the voltage $V_{cc}$. Accompanied by an increase in potential at the node $N_1$, the potential of the opposed electrode $OE_1$ and, therefore, of the word line $WL_2$ adjacent to the word line $WL_1$ is increased via the MOS capacitor $C_1$. It is not preferable that the potential of the non-selected word line $WL_2$ be increased since the word line $WL_2$ is not being selected at this time. Although the word decoder $WD_2$ clamps the word line $WL_2$ at one end thereof at the voltage $V_{ss}$ (generally 0 V), and increase in potential of the non-selected word line $WL_2$ still occurs since a clamping effect is not satisfactorily obtained due to the resistances $R_1$, $R_2$, ... (Fig. 1) of the word lines and since the word lines are of polycrystalline silicon having larger resistances than those of metal wiring. Thus, the potential of the word line $WL_2$ is increased temporarily and locally by a boost via the above-mentioned capacitor $C_1$. If the potential of the word line $WL_2$ increases to more than the threshold voltage of the MOS transistor $Q_2$, the memory cell $MC_2$ is erroneously turned on. If the state of the memory cell $MC_2$ is "1", i.e., if the node $N_2$ is voltage at the voltage $V_{cc}$, no problem occurs. If, however, the state of the memory cell $MC_2$ is "0", i.e., if the node $N_2$ is at the voltage $V_{ss}$, the transistor $Q_2$ is turned on so that a current flows from the bit line $\overline{BL}$, which has been precharged to the voltage $V_{cc}$, to the node $N_2$, resulting in an increase of the potential at the node $N_2$. This is the reason why the level of the node $N_2$ in Fig. 2 increases. Even after the potential of the word line $WL_2$ is lowered to the voltage $V_{ss}$, by means of the word decoder $WD_2$ connected to one end of the word line $WL_2$, so as to clamp the word line $WL_2$, the potential of the node $N_2$ does not return to the voltage $V_{ss}$.

The operation of reading the data stored in a memory cell, for example, $MC_2$, is, as is well known, carried out by precharging the bit line BL and $\overline{BL}$ to the voltage $V_{cc}$ and then selecting the word line $WL_2$ so as to raise the potential thereof and therefore turn on the MOS transistor $Q_2$ having a drain connected to the bit line $\overline{BL}$ and functioning as a transfer gate. Simultaneous with the turning on of the MOS transistor $Q_2$, a transfer gate of a dummy cell (not shown) connected to the bit line BL is turned on. The dummy cell stores a reference charge. Thus, charges on the bit lines BL and $\overline{BL}$ are caused to flow into the dummy cell and the real cell $MC_2$, respectively. The difference between the charges caused to flow into the real cell $MC_2$ and the charges caused to flow into the dummy cell, or more exactly the potential difference between the bit lines BL and $\overline{BL}$, is detected by the sense amplifier SA.

If, as was previously mentioned, the potential of the node $N_2$ is erroneously increased, the amount of charge caused to flow from the bit line $\overline{BL}$ to the real cell $MC_2$ is too small to indicate that the memory cell $MC_2$ is storing "0". Thus, a reading error may occur.

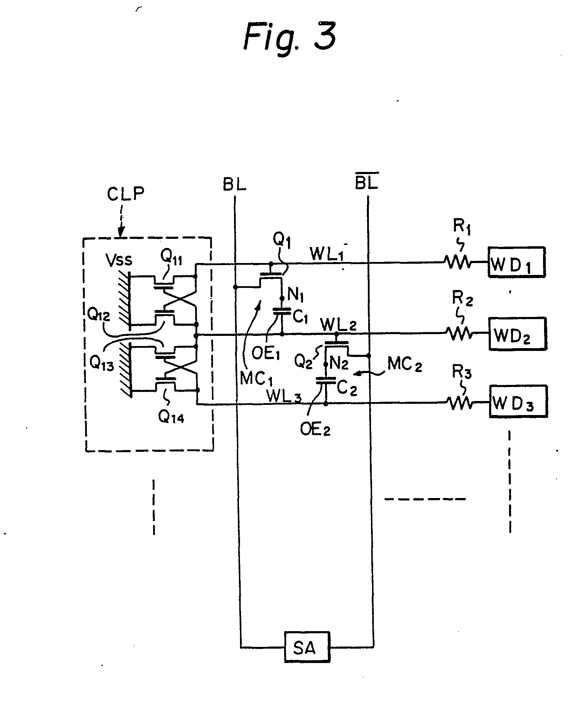

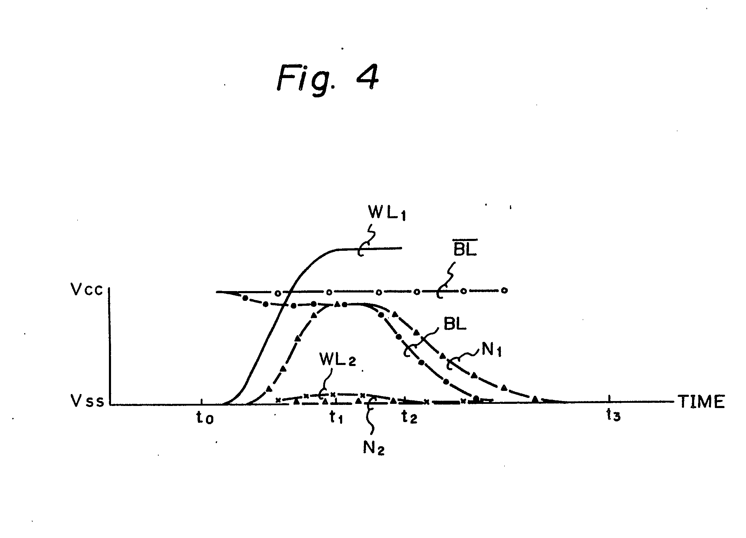

Figure 3 shows an embodiment of the present invention, wherein the same portions as in Fig. 1 are denoted by the same reference numerals and symbols. In Fig. 3, the element enclosed within the broken lines is a clamping circuit CLP, which is an additional element in this embodiment. The structure of the clamping circuit CLP is simple, that is, between the left end of the word line $WL_1$ and the left end of the word line $WL_2$ (the open ends of the word lines $WL_1$ and $WL_2$ in Fig. 1) and the voltage $V_{ss}$, cross-coupled transistors $Q_{11}$ and $Q_{12}$ constituting a flip-flop are connected, and between the left end of the word line $WL_2$ and the left end of the word line $WL_3$ and the voltage $V_{ss}$, similar transistors $Q_{13}$ and $Q_{14}$ constituting a flip-flop are connected. In such a structure, when the word line $WL_1$ is selected, the transistor $Q_{12}$ is turned on so that one end of the non-selected word line $WL_2$ adjacent to the word line $WL_1$ is clamped at the voltage $V_{ss}$ and the other end thereof is clamped at the voltage $V_{ss}$ by the word decoder $WD_1$. Accordingly, as is shown in Fig. 4, although the changes in potential of the selected word line $WL_1$ and the node $N_1$ are the same as those in Fig. 2, the potential increase of the non-selected word line $WL_2$ can be kept small so that the MOS transistor $Q_2$ is not turned on thereby preventing inversion of the data stored in memory cell $MC_2$. Similarly, when the word line $WL_2$ is selected, the transistor $Q_{14}$ is turned on so that one end of the word line $WL_3$ is clamped at the voltage $V_{ss}$, thereby preventing inversion of the data stored in a memory cell connected to the word line $WL_3$.

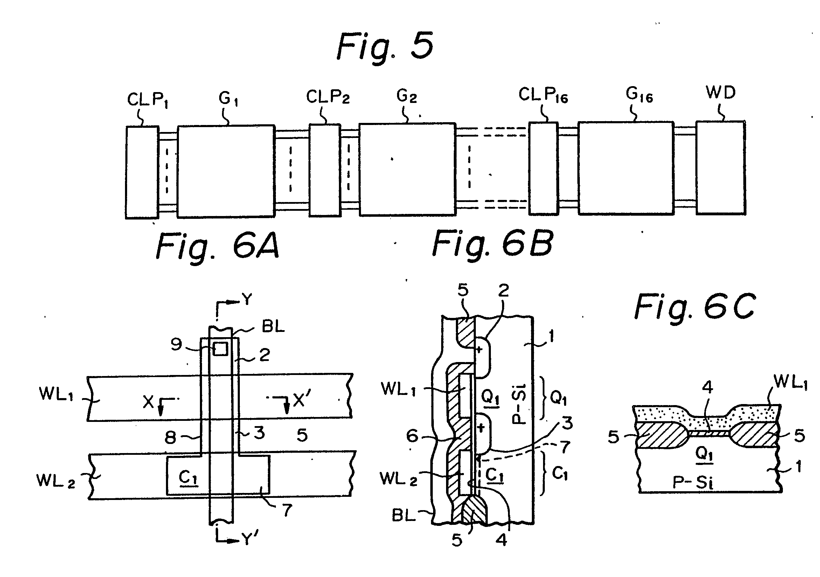

It is apparent that the effect is increased by providing a plurality of clamping circuits CLP in the word line direction, that is, by making one clamping circuit work at only one part of a word line, as is illustrated in Fig. 5.

Figure 5 is a block diagram of a 64K DRAM having a memory-cell matrix of 256×256 bits, the memory-cell matrix being divided into 16 groups $G_1$ to $G_{16}$ in the word line direction, and clamping circuits $CLP_1$ to $CLP_{16}$ being inserted between two adjacent groups. Since one clamping circuit, including one flip-flop consisting of the transistors $Q_{11}$ and $Q_{12}$, for example, can be formed with a 12 μm width, the total width of the clamping circuits is only about 200 μm.

Figure 6A to 6C are diagrams showing the structure of the memory cell $MC_1$ as an example

included in the DRAM of Fig. 3, Fig. 6A being a plan pattern, Fig. 6B a cross section along the line X—X' of Fig. 6A, and Fig. 6C a cross section along the line Y—Y' of Fig. 6A. In these figures, 1 is a P-type silicon substrate, 2 and 3 are $N^+$-type diffusion layers which act as source and drain regions of the transistor $Q_1$, 4 is a gate oxidation film, 5 is a field oxidation film, 6 is an insulating layer between layers, 7 is an N-type insertion layer formed by means of an ion implantation technique and so on, 8 represents a boundary of the field oxidation film 5 and 9 is a contact hole connecting the bit line BL of aluminium to the $N^+$-type diffusion layer 2. The word lines $WL_1$ and $WL_2$ are polycrystalline silicon layers. The word line $WL_2$ adjacent to the word line $WL_1$ is used as the opposed electrode of the MOS capacitor $C_1$. The bit line BL is an aluminium (Al) layer which is in ohmic contact with one of the $N^+$-type layers, i.e., the layer 2, of the transistor $Q_1$. To obtain a desired capacitance of the capacitor $C_1$, the inversion layer 7 is extended under the word line $WL_2$.

## Claims

1. A dynamic semiconductor memory device comprising:
    a plurality of word lines ($WL_1$, $WL_2$...);
    a plurality of bit lines (BL, $\overline{BL}$);
    one-transistor one-capacitor type memory cells ($MC_1$, $MC_2$) connected between the word lines and the bit lines; and clamping circuitry (CLP), comprising a plurality of flips-flops, for clamping non-selected word lines to a low voltage (VSS) of a power source;
    characterised in that in each memory cell, the transistor (e.g. $Q_1$) has a gate connected to a certain one of the word lines (e.g. $WL_1$), a first electrode connected to one of the bit lines, and a second electrode, and the capacitor (e.g. $C_1$) has an electrode connected through a node (e.g. $N_1$) to the second electrode of the transistor, and has another electrode connected to the word line (e.g. $WL_2$) adjacent to said certain one word line, the two electrodes of the capacitor being opposed through an insulating film; and in that
    said clamping circuitry (CLP) comprises:
    a respective flip-flop connected between each word line (e.g. $WL_1$) and each adjacent word line (e.g. $WL_2$), whereby each flip-flop is connected to a pair of word lines and each word line is connected to two flip-flops, each flip-flop being operable to clamp a non-selected one of the pair of word lines to which it is connected at the low voltage (VSS) of said power source; and each flip-flop comprising a pair of cross-coupled transistors (e.g. $Q_{11}$, $Q_{12}$) each having a gate connected to a respective one of the pair of word lines (e.g. $WL_1$, $WL_2$).

2. A dynamic semiconductor memory device as set forth in claim 1, wherein said pair of cross-coupled transistors (e.g. $Q_{11}$, $Q_{12}$) comprises:
    a first MIS transistor ($Q_{11}$) and a second MIS transistor ($Q_{12}$), said first MIS transitor ($Q_{11}$) having a drain connected to one word line ($WL_1$)

of said pair of word lines, a gate connected to the other word line ($WL_2$) of said pair of word lines, and a source connected to a low voltage terminal (VSS) of said power source and said second MIS transistor ($Q_{12}$) having a drain connected to said other word line ($WL_2$) of said pair of word lines, a gate connected to said one word line ($WL_1$) of said pair of word lines, and a source connected to said low voltage terminal (VSS) of said power source.

3. A dynamic semiconductor memory device as set forth in claim 1 or 2, wherein said flip-flops are arranged on plural portions of said pair of word lines.

## Patentansprüche

1. Dynamische Halbleiterspeichervorrichtung mit:
    einer Vielzahl von Wortleitungen ($WL_1$, $WL_2$...);
    einer Vielzahl von Bitleitungen (BL, $\overline{BL}$);
    Speicherzellen ($MC_1$, $MC_2$) vom ein-Transistor-ein-Kondensator-Typ, die zwischen den Wortleitungen und den Bitleitungen verbunden sind; und einer Klammerschaltung (CLP), die eine Vielzahl von Flipflops umfaßt, um nichtausgewählte Wortleitungen auf eine niedrige Spannung (VSS) einer Energiequelle zu klammern;
    dadurch gekennzeichnet, daß in jeder Speicherzelle der Transistor (z.B. $Q_1$) ein Gate hat, das mit einer gewissen der Wortleitungen (z.B. $WL_1$) verbunden ist, eine erste Elektrode, die mit einer der Bitleitungen verbunden ist, und eine zweite Elektrode, und der Kondensator (z.B. $C_1$) eine Elektrode, die über einen Knoten (z.B. $N_1$) mit der zweiten Elektrode des Transistors verbunden ist, und eine andere Elektrode hat, die mit der Wortleitung (z.B. $WL_2$) neben der genannten gewissen einen Wortleitung verbunden ist, wobei die beiden Elektroden des Kondensators auf gegenüberliegenden Seiten eines isolierenden Films sind; und daß
    die genannte Klammerschaltung (CLP) umfaßt:
    ein jeweiliges Flipflop, welches zwischen jeder Wortleitung (z.B. $WL_1$) und jeder benachbarten Wortleitung (z.B. $WL_2$) verbunden ist, wodurch jedes Flipflop mit einem Paar von Wortleitungen verbunden ist und jede Wortleitung mit zwei Flipflops verbunden ist, jedes Flipflop betreibbar ist, um eine nichtausgewählte des Paares von Wortleitungen, mit welchem es verbunden ist, an die niedrige Spannung (VSS) der genannten Energiequelle zu klammern; und jedes Flipflop ein Paar von kreuzweise gekoppelten Transistoren (Z.B. $Q_{11}$, $Q_{12}$) umfaßt, die jeweils ein Gate haben, das mit einem entsprechenden von dem Paar von Wortleitungen (z.B. $WL_1$, $WL_2$) verbunden ist.

2. Dynamische Halbleiterspeichervorrichtung nach Anspruch 1, bei der das genannte Paar von kreuzweise gekoppelten Transistoren (z.B. $Q_{11}$, $Q_{12}$) umfaßt:
    einen ersten MIS-Transistor ($Q_{11}$) und einem zweiten MIS-Transistor ($Q_{12}$), welcher genannte erste MIS-Transistor ($Q_{11}$) ein Drain hat, das mit einer Wortleitung ($WL_1$) des genannten Paares von Wortleitungen verbunden ist, ein Gate, das mit der anderen Wortleitung (WL₂) des genannten Paares von Wortleitungen verbunden ist, und eine Source, die mit einem Niedrigspannungsanschluß (VSS) der genannten Energiequelle verbunden ist, und der genannten zweite MIS-Transistor (Q₁₂) ein Drain hat, das mit der genannten anderen Wortleitung (WL₂) des genannten Paares von Wortleitungen verbunden ist, ein Gate, das mit der genannten einen Wortleitung (WL₁) des genannten Paares von Wortleitungen verbunden ist, und eine Source, die mit dem genannten Niedrigspannungsanschluß (VSS) der genannten Energiequelle verbunden ist.

3. Dynamische Halbleiterspeichervorrichtung nach Anspruch 1 oder 2, bei der die genannten Flipflops auf vielen Abschnitten des genannten Paares von Wortleitungen angeordnet sind.

**Revendications**

1. Dispositif de mémoire semi-conductrice dynamique comportant:
   plusieurs lignes de mots (WL₁, WL₂...);
   plusieurs lignes de bits (BL, $\overline{BL}$);
   des cellules de mémoire (MC₁, MC₂), du type à transistor et un condensateur connectées entre les lignes de mots et les lignes de bits; et un circuits de verrouillage (CLP) comprenant plusieurs circuits bistables pour verrouiller les lignes de mots non sélectionnées à une tension basse (VSS) d'une source d'alimentation;
   caractérisé en ce que, dans chaque cellule de mémoire, le transistor (p.e. Q₁) comporte une grille connectée à une certaine des lignes de mots (p.e. WL₁), une première électrode connectée à l'une des lignes de bits et une seconde électrode et le condensateur (p.e. C₁) comporte une électrode connectée par un point commun (p.e. N₁) à la seconde électrode du transistor et une autre électrode connectée à la ligne de mots (p.e. WL₂) voisine de ladite certaine ligne de mots, les deux électrodes du condensatsur étant opposées par l'intermédiaire d'une pellicule isolante; et en ce que
   ledit circuit de verrouillage (CLP) comporte:
   un circuit bistable respectif connecté entre chaque ligne de mots (p.e. WL₁) et chaque ligne de mots voisine (p.e. WL₂) de manière que chaque circuit bistable soit connecté à une paire de lignes de mots et que chaque ligne de mots soit connectée à deux circuits bistables, chaque circuit bistable ayant pour fonction de verrouiller l'une non sélectionnée de la paire de lignes de mots à laquelle il est connecté à la tension basse (VSS) de ladite source d'alimentation et chaque circuit bistable consistant en une paire de transistors couplés en croix (p.e. Q₁₁, Q₁₂) avec chacun une grille connectée à l'une particulière de la paire de lignes de mots (p.e. WL₁, WL₂).

2. Dispositif de mémoire semi-conductrice dynamique selon la revendication 1, dans lequel ladite paire de transistors couplés en croix (p.e. Q₁₁, Q₁₂) comporte:
   un premier transistor MIS (Q₁₁) et un second transistor MIS (Q₁₂), ledit premier transistor MIS (Q₁₁) comprenant un drain connecté à une ligne de mots (WL₁) de ladite paire de lignes de mots, une grille connectée à l'autre ligne de mots (WL₂) de ladite paire de lignes de mots et une source connectée à une borne de tension basse (VSS) de ladite source d'alimentation et ledit second transistor MIS (Q₁₂) ayant un drain connecté à ladite autre ligne de mots (WL₂) de ladite paire de lignes de mots, une grille connectée à ladite ligne de mots (WL₁) de ladite paire de lignes de mots et une source connectée à ladite borne de tension basse (VSS) de ladite source d'alimentation.

3. Dispositif de mémoire semi-conductrice dynamique selon la revendication 1 ou 2, dans lequel lesdits circuits bistables sont disposés dans plusieurs parties de ladite paire de lignes de mots.

Fig. 1

Fig. 2

# Fig. 3

EP 0 107 921 B1

# Fig. 4

# Fig. 5

CLP₁  G₁  CLP₂  G₂  CLP₁₆  G₁₆  WD

# Fig. 6A   Fig. 6B   Fig. 6C

EP 0 107 921 B1